# EUROPEAN PATENT APPLICATION

(11) **EP 4 025 028 A2**
(43) Date of publication of application: **06.07.2022**
(21) Application number: 22170244.2
(22) Date of filing: 27.04.2022
(51) Int. Cl.: H05K 7/20

(54) **COOLING APPARATUS AND METHOD**

(30) Priority: 29.04.2021 CN 202110477595
(71) Applicant: Beijing Baidu Netcom Science and Technology Co., Ltd., Beijing 100085 (CN)
(72) Inventor: XIN, Yi, Beijing, 100085 (CN); WU, Shuanghe, Beijing, 100085 (CN); CHAI, Hongbin, Beijing, 100085 (CN)
(74) Representative: Carpmaels & Ransford LLP

(57) **Abstract**

A cooling apparatus (200) and method related to the field of data center and specifically related to the technical field of a refrigeration device are provided. The data center may be used for data transmission under application scenes such as cloud computing, cloud services, etc.. The cooling apparatus (200) includes: a main body (210); a plurality of first fluid channels (220A, 220B, 220C) provided in the main body (210); at least one second fluid channel (230A, 230B) provided in the main body (210), each second fluid channel (230A, 230B) being provided between two adjacent first fluid channels (220A, 220B, 220C) of the plurality of first fluid channels (220A, 220B, 220C), and adjoining the two adjacent first fluid channels (220A, 220B, 220C); and a spacer (240A, 240B, 240C) provided in each second fluid channel (230A, 230B), the spacer (240A, 240B, 240C) being configured to divide each second fluid channel (230A, 230B) into a plurality of sub-channels (231, 232, 233, 234, 235).

## Description

### TECHNICAL FIELD

The present disclosure relates to the field of data center, specifically relates to the technical field of refrigeration device, and in particular to a cooling apparatus and method.

### BACKGROUND

In the related art, a cooling apparatus is generally used to cool a fluid to be cooled, and the cooling apparatus includes, for example, an air-to-air heat exchanger. However, a cooling efficiency of the cooling apparatus in the related art is relatively low, and the cooling effect is not good. In addition, when spraying a spray liquid to the cooling apparatus through a sprayer to cool the cooling apparatus, requirements for the spray liquid are relatively high. When the spray liquid is mixed with various impurities, the sprayer will be blocked, thereby decreasing a cooling effect on the cooling apparatus.

### SUMMARY

According to the embodiments of the present disclosure, a cooling apparatus is provided, including: a main body; a plurality of first fluid channels provided in the main body; at least one second fluid channel provided in the main body, wherein each second fluid channel is provided between two adjacent first fluid channels of the plurality of first fluid channels, and adjoins the two adjacent first fluid channels; and a spacer provided in each second fluid channel, wherein the spacer is configured to divide each second fluid channel into a plurality of sub-channels.

According to the embodiments of the present disclosure, a cooling method implemented by a cooling apparatus is provided, wherein the cooling apparatus includes: a main body; a plurality of first fluid channels provided in the main body; at least one second fluid channel provided in the main body, each second fluid channel of the at least one second fluid channel being provided between two adjacent first fluid channels of the plurality of first fluid channels, and adjoining the two adjacent first fluid channels; and a spacer provided in each second fluid channel, the spacer being configured to divide each second fluid channel into a plurality of sub-channels; the method includes: introducing a fluid into at least one of the plurality of sub-channels.

It should be understood that, the content described in this section is not intended to characterize the key or vital features of the embodiments of the present disclosure, and is not used to limit the scope of the present disclosure. With the following description, other features of the present disclosure will become easily understood.

### BRIEF DESCRIPTION OF THE DRAWINGS

The accompanying drawings are used for a better understanding of the present disclosure, rather than limiting the present disclosure, in which:
FIG. 1 schematically shows an application scene of a cooling apparatus according to an embodiment of the present disclosure;
FIG. 2 schematically shows an application scene of a cooling apparatus according to another embodiment of the present disclosure;
FIG. 3 schematically shows a schematic diagram of a cooling apparatus according to an embodiment of the present disclosure;
FIG. 4 schematically shows a schematic diagram of a spacer according to an embodiment of the present disclosure;
FIG. 5 schematically shows a schematic diagram of a cooling apparatus according to another embodiment of the present disclosure;
FIG. 6 schematically shows a schematic diagram of a cooling apparatus according to another embodiment of the present disclosure;
FIG. 7 schematically shows a schematic diagram of a direction of a channel according to an embodiment of the present disclosure;
FIG. 8 schematically shows a schematic diagram of a distribution of a spacer according to an embodiment of the present disclosure; and
FIG. 9 schematically shows a schematic diagram of a cooling apparatus according to another embodiment of the present disclosure

### DETAILED DESCRIPTION OF EMBODIMENTS

In the following, exemplary embodiments of the present disclosure will be described with reference to the accompanying drawings, wherein various details of the present disclosure are included for understanding, and they should be considered as merely illustrative. Therefore, those of ordinary skilled in the art should recognize that various changes and modifications may be made to the embodiments described herein, without departing from the scope and the spirit of the present disclosure. Also, for clarity and conciseness, descriptions of well-known functions and structures are omitted in the following descriptions.

The terms used herein are for describing specific embodiments only, and is not intended to limit the present disclosure. The terms "including", "comprising", etc. used herein indicate the presence of features, steps, operations and/or components, but do not exclude the presence or addition of one or more other features, steps, operations or components.

Unless otherwise defined, all the terms (including the scientific terms and technical terms) used herein have the meanings generally understood by those of ordinary skilled in the art. It should be noted that, the terms used herein should be construed as having the meanings consistent with the context of the present disclosure, and should be explained in an idealized or overly rigid manner.

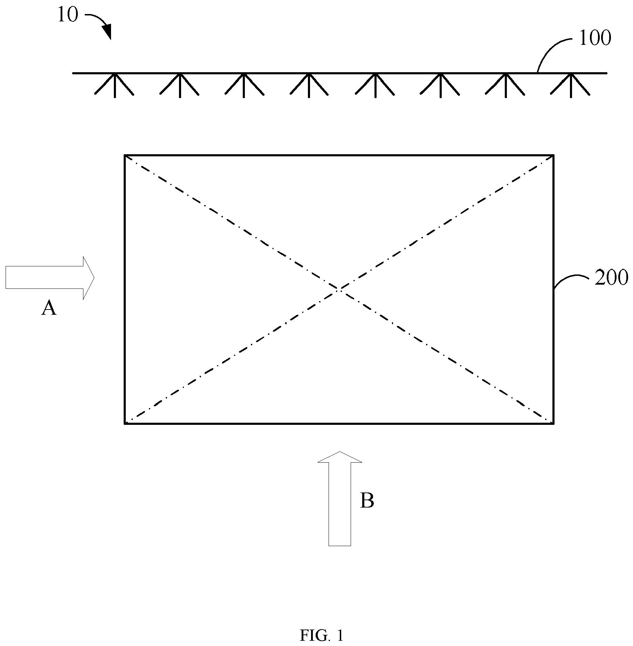

FIG. 1 schematically shows an application scene of a cooling apparatus according to an embodiment of the present disclosure.

As shown in FIG. 1, the application scene 10 according to the embodiment of the present disclosure includes a sprayer 100 and a cooling apparatus 200. The sprayer 100 includes, for example, a spray head for spraying a spray liquid. The cooling apparatus 200 includes, for example, an air-to-air heat exchanger.

In an example, a fluid to be cooled enters the cooling apparatus 200 in a direction A. The fluid to be cooled may be, for example, indoor hot air. For example, the fluid to be cooled may be hot air from a data center. The data center may be used for transmission of data under application scenes such as cloud computing, cloud services, etc..

A cooling medium enters the cooling apparatus 200 in a direction B, and the cooling medium includes, for example, a cold air from the external environment. Heat exchange is performed between the cooling medium and the fluid to be cooled in the cooling apparatus 200, so as to achieve a cooling treatment of the fluid to be cooled with the cooling medium. The cooled fluid may return to the data center to take away heat generated in the data center.

In an example, the sprayer 100 may, for example, spray the spray liquid to the cooling apparatus 200, so as to cool the cooling apparatus 200 through the spray liquid.

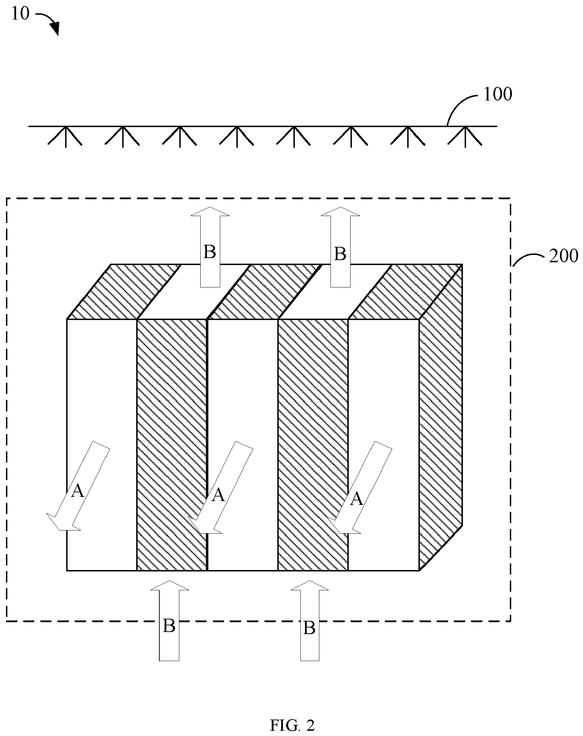

FIG. 2 schematically shows an application scene of a cooling apparatus according to another embodiment of the present disclosure.

As shown in FIG. 2, the cooling apparatus 200 includes, for example, a plurality of first fluid channels and a plurality of second fluid channels. A fluid to be cooled passes through a first fluid channel, and a flow direction of the fluid to be cooled may be, for example, a direction A. A cooling medium passes through a second fluid channel, and a flow direction of the cooling medium may be a direction B. The first fluid channel and the second fluid channel are independent of each other. That is, the fluid to be cooled in the first fluid channel does not mix with the cooling medium in the second fluid channel.

When the sprayer 100 sprays the spray liquid to the cooling apparatus 200, the spray liquid may pass through a second fluid channel, and cool a cooling medium in the second fluid channel. The spray liquid may fall into a bottom of the cooling apparatus 200 after passing through the second fluid channel from up to down. The spray liquid at the bottom may be pumped into the sprayer 100 by a water pump, so as to be sprayed out again.

In an example, the cooling medium may be outside air, and the spray liquid may be a liquid. Since the spray liquid mixes with the cooling medium, impurities in the outside air enters into the spray liquid, which may cause a nozzle of the sprayer to be easily blocked, and the sprayed spray liquid may be uneven, thereby decreasing a cooling effect of the sprayer on the cooling apparatus.

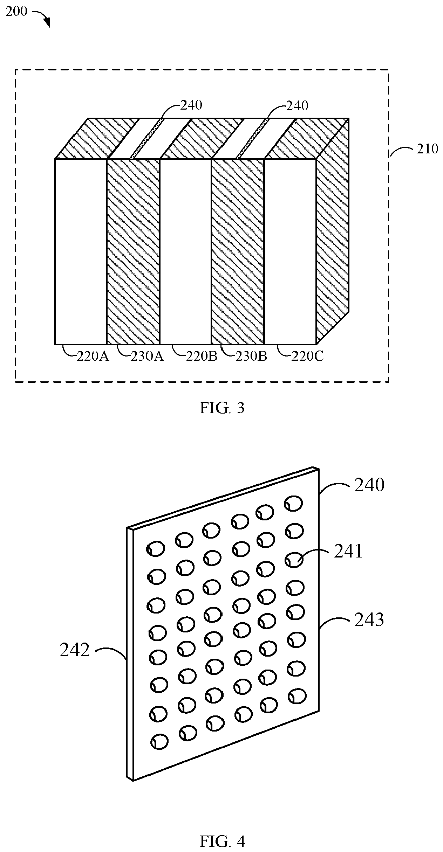

The cooling apparatuses shown in FIG. 1 and FIG. 2 have a problem of poor cooling effect. In view of this, the embodiments of the present disclosure provide an optimized cooling apparatus. The cooling apparatus includes: a main body, a plurality of first fluid channels, at least one second fluid channel, and a spacer. The plurality of first fluid channels are provided in the main body. The at least one second fluid channel is provided in the main body. Each second fluid channel is provided between two adjacent first fluid channels of the plurality of first fluid channels, and adjoins the two adjacent first fluid channels. The spacer is provided in each second fluid channel, and is used to divide each second fluid channel into a plurality of sub-channels. The cooling apparatus according to the embodiments of the present disclosure will be described with reference to FIGS. 3 to 9.

FIG. 3 schematically shows a schematic diagram of a cooling apparatus according to an embodiment of the present disclosure.

As shown in FIG. 3, the cooling apparatus 200 according to the embodiment of the present disclosure includes: a main body 210, a plurality of first fluid channels, at least one second fluid channel, and a spacer 240.

The plurality of first fluid channels and the at least one second fluid channel are provided in, for example, the main body 210. Each second fluid channel is provided between two adjacent first fluid channels of the plurality of first fluid channels, and adjoins the two adjacent first fluid channels. The first fluid channels and the second fluid channels are arranged in sequence. The "adjoin" includes a contact or a connection.

In an example, the plurality of first fluid channels includes, for example, a first fluid channel 220A, a first fluid channel 220B, and a first fluid channel 220C. The at least one second fluid channel includes, for example, a second fluid channel 230A and a second fluid channel 230B. It should be understood that a second fluid channel is provided between two adjacent first fluid channels, for example, the second fluid channel 230A is provided between two adjacent first fluid channels 220A and 220B. In an example, in a case that the plurality of first fluid channels include two first fluid channels, the number of the second fluid channel according to an embodiment of the present disclosure is, for example, one.

The spacer 240 is, for example, provided in each second fluid channel. The spacer 240 is used to divide each second fluid channel into a plurality of sub-channels.

For example, the fluid to be cooled may pass through each first fluid channel. For example, the cooling medium may pass through each second fluid channel, and the cooling medium is used to cool the fluid to be cooled. The cooling medium includes a liquid or a gas. The cooling medium may pass through each sub-channel of the second fluid channel.

For example, for the plurality of sub-channels of each second fluid channel, liquids may pass through some of the plurality of sub-channels, and gases may pass through others of the plurality of sub-channels. The liquids or the gases may be used to cool fluids to be cooled in the first fluid channels. Heat may be exchanged between the liquids and the gases in different sub-channels, so as to cool the liquids by using the gases, or cool the gases by using the liquids.

It should be understood that in the related art, the second fluid channel is generally used to cool a fluid to be cooled in a first fluid channel by using a gas. However, the cooling efficiency by using the gas only is relatively low. Therefore, in the embodiments of the present disclosure, the second fluid channel is divided into a plurality of sub-channels by using the spacer, and a liquid and a gas may pass through different sub-channels. The liquid and the gas passing through the plurality of sub-channels may be used to cool fluids to be cooled in the first fluid channels, thereby improving the cooling effect on the fluids to be cooled.

In addition, in the related art, the sprayer is generally used to spray the spray liquid to the cooling apparatus so as to cool a fluid to be cooled. However, since there may be impurities in the spray liquid, the nozzle of the sprayer may be easily blocked. In the embodiments of the present disclosure, the spacer is used to divide the second fluid channel into a plurality of sub-channels. Instead of spraying the spray liquid for cooling by using an external sprayer, some of the plurality of sub-channels are used for cooling the fluids to be cooled through liquids, thereby avoiding the problem that the impurities in the spray liquid may block the nozzle of the sprayer.

FIG. 4 schematically shows a schematic diagram of a spacer according to an embodiment of the present disclosure.

As shown in FIG. 4, the spacer 240 according to the embodiment of the present disclosure includes, for example, a through hole 241. Any two adjacent sub-channels of the plurality of sub-channels communicate with each other through the through hole 241. The cooling mediums in different sub-channels may contact each other through the through hole for heat exchange.

In an example, the spacer includes, for example, a first surface 242 and a second surface 243. Each through hole passes through, for example, the first surface 242 and the second surface 243. In an example, the spacer 240 may be, for example, a mesh screening. The mesh screening may cause a liquid passing through a sub-channel to disperse and flow, and the fluid to be cooled may be fully cooled by the dispersed liquid.

It should be understood that, heat may be exchanged between the liquid and the gas in different sub-channels. After a liquid in a sub-channel cools a fluid to be cooled in a first fluid channel, a temperature of the liquid in the sub-channel increases, while a gas in another sub-channel may be used to cool the liquid, so that the cooling effect of the liquid improves, thereby ensuring the cooling effect of the liquid on the fluid to be cooled. The spacer is provided between the sub-channel through which the liquid passes and the sub-channel through which the gas passes. The spacer is provided with the through hole communicating the plurality of sub-channels, so that the liquid and the gas in different sub-channels may be in contact with each other, thereby improving the heat exchange effect of the liquid and the gas in different sub-channels.

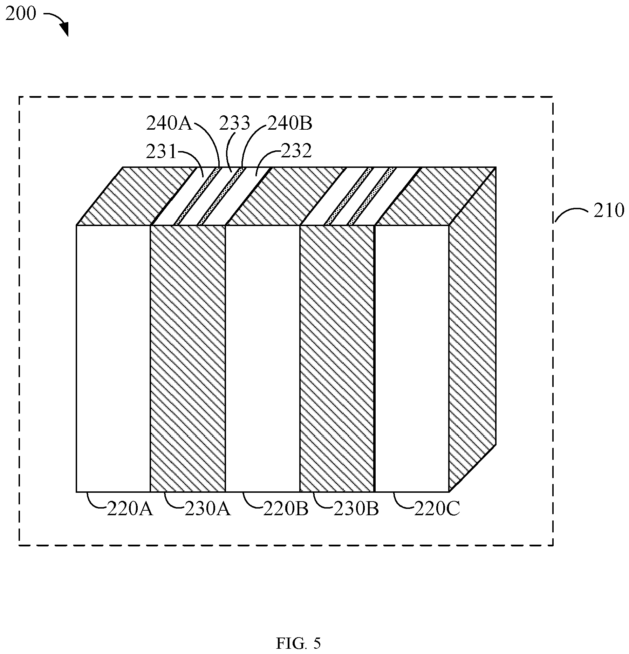

FIG. 5 schematically shows a schematic diagram of a cooling apparatus according to another embodiment of the present disclosure.

As shown in FIG. 5, the cooling apparatus 200 according to the embodiment of the present disclosure includes: a main body 210, a plurality of first fluid channels, at least one second fluid channel, and a plurality of spacers.

The plurality of first fluid channels include, for example, a first fluid channel 220A, a first fluid channel 220B, and a first fluid channel 220C. The at least one second fluid channel includes, for example, a second fluid channel 230A and a second fluid channel 230B.

In an example, two spacers are provided in each second fluid channel, and are used to divide the second fluid channel into three sub-channels. Taking the second fluid channel 230A as an example, a spacer 240A and a spacer 240B divide the second fluid channel 230A into three sub-channels. The three sub-channels include, for example, a first sub-channel 231, a second sub-channel 232 and a third sub-channel 233.

In an example, the second fluid channel 230A adjoins, for example, two adjacent first fluid channels. The two adjacent first fluid channels include, for example, the first fluid channel 220A and the first fluid channel 220B.

The first sub-channel 231 adjoins, for example, one of the two adjacent first fluid channels. For example, the first sub-channel 231 adjoins the first fluid channel 220A.

The second sub-channel 232 adjoins, for example, the other one of the two adjacent first fluid channels. For example, the second sub-channel 232 adjoins the first fluid channel 220B.

The third sub-channel 233 is, for example, provided between the first sub-channel 231 and the second sub-channel 232.

In an example, cooling mediums may pass through, for example, the first sub-channel 231, the second sub-channel 232 and the third sub-channel 233, so that the cooling mediums are used to cool the fluids to be cooled in the first fluid channels. The cooling mediums may include a liquid or a gas.

In an example, the first sub-channel 231 and the second sub-channel 232 may be used, for example, for liquids to pass through. Since the cooling effect of the liquid is relatively good, the first sub-channel 231 and the second sub-channel 232 adjoining the first fluid channels are used for liquids to pass through, so that the liquids may be used to cool the fluids to be cooled in the first fluid channels, thereby improving the cooling efficiency and the cooling effect.

In an example, the third sub-channel 233 may be used, for example, for a gas to pass through. The gas may be used to cool the liquid in the first sub-channel 231 and the liquid in the second sub-channel 232. The first sub-channel 231 and the third sub-channel 233 are separated by the spacer 240A provided with a through hole, and the second sub-channel 232 and the third sub-channel 233 are separated by the spacer 240B provided with a through hole. Therefore, the gas may be in contact with the liquids through the through holes for heat exchange, thereby improving the cooling effect of the liquids, and further improving the cooling effect of the liquids on the fluids to be cooled.

In an example, any one or more of the first sub-channel 231 and the second sub-channel 232 includes a curved structure. For example, the first sub-channel 231 and the second sub-channel 232 may be provided as curved return channels. Alternatively, the first sub-channel 231 and the second sub-channel 232 may include curved grooves inside. It should be understood that the curved structure may cause a contact area between the liquid and the first fluid channel to increase, thereby improving the cooling efficiency of the liquid on the fluid to be cooled in the first fluid channel. In addition, the curved structure may cause a flow speed of the liquid to reduce, thereby increasing a cooling time of the liquid on the fluid to be cooled in the first fluid channel, and improving the cooling efficiency. The curved structure may also cause the liquid to form an evenly distributed water film in the channel, thereby improving the cooling effect.

In another example, no liquid passes through the first sub-channel 231 and the second sub-channel 232, and a gas may pass through the third sub-channel 233. The gas in the third sub-channel 233 may enter the first sub-channel 231 and the second sub-channel 232 via the through hole in the spacer, so that the gas may be in contact with the first fluid channel, thereby cooling the fluid to be cooled in the first fluid channel by using the gas.

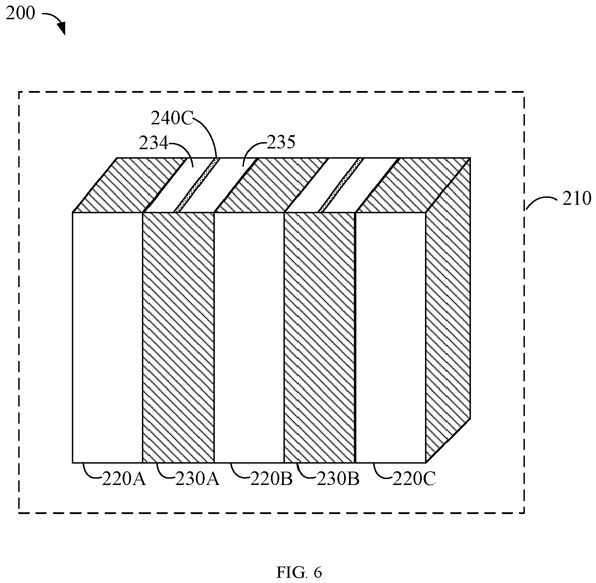

FIG. 6 schematically shows a schematic diagram of a cooling apparatus according to another embodiment of the present disclosure.

As shown in FIG. 6, the cooling apparatus 200 according to the embodiment of the present disclosure includes: a main body 210, a plurality of first fluid channels, at least one second fluid channel, and a spacer.

The plurality of first fluid channels include, for example, a first fluid channel 220A, a first fluid channel 220B, and a first fluid channel 220C. The at least one second fluid channel includes, for example, a second fluid channel 230A and a second fluid channel 230B.

In an example, one spacer is provided in each second fluid channel and used to divide the second fluid channel into two sub-channels. Taking the second fluid channel 230A as an example, a spacer 240C divides the second fluid channel 230A into two sub-channels. The two sub-channels include, for example, a fourth sub-channel 234 and a fifth sub-channel 235.

In an example, the second fluid channel 230A adjoins, for example, two adjacent first fluid channels. The two adjacent first fluid channels include, for example, the first fluid channel 220A and the first fluid channel 220B.

The fourth sub-channel 234 adjoins, for example, one of the two adjacent first fluid channels. For example, the fourth sub-channel 234 adjoins the first fluid channel 220A.

The fifth sub-channel 235 adjoins, for example, the other one of the two adjacent first fluid channels. For example, the fifth sub-channel 235 adjoins the first fluid channel 220B.

In an example, the fourth sub-channel 234 and the fifth sub-channel 235 are used, for example, for cooling mediums to pass through, so that the cooling mediums are used to cool the fluids to be cooled in the first fluid channels. The cooling mediums may include a liquid or a gas.

The fourth sub-channel 234 may be used, for example, for a liquid to pass through, and the liquid may be used to cool a fluid to be cooled in the first fluid channel 220A. The fifth sub-channel 235 may be used, for example, for a gas to pass through, and the gas may be used to cool a fluid to be cooled in the first fluid channel 220B. Since the cooling effect of the liquid is relatively good, a temperature of the liquid in the fourth sub-channel 234 is generally higher. In addition to cooling the fluid to be cooled in the first fluid channel 220B, the gas in the fifth sub-channel 235 may be further used to cool the liquid in the fourth sub-channel 234. For example, the fourth sub-channel 234 and the fifth sub-channel 235 are separated by a spacer provided with a through hole. The gas may be in contact with the liquid through the through hole for heat exchange, thereby improving the cooling effect of the liquid, and further improving the cooling effect of the liquid on the fluid to be cooled. Both the liquid and the gas are used to cool the fluid to be cooled, thereby improving the cooling efficiency and the cooling effect.

In an example, the fourth sub-channel 234 used for the liquid to pass through includes a curved structure. For example, the fourth sub-channel 234 may be provided as a curved return channel. Alternatively, the fourth sub-channel 234 may include a curved groove inside. It should be understood that the curved structure may cause a contact area between the liquid and the first fluid channel to improve, thereby improving the cooling efficiency of the liquid on the fluid to be cooled in the first fluid channel. In addition, the curved structure may reduce a flow speed of the liquid, thereby increasing a cooling time of the liquid on the fluid to be cooled in the first fluid channel, and improving the cooling efficiency. The curved structure may also cause the liquid to form an evenly distributed water film in the channel, thereby improving the cooling effect.

In another example, no liquid passes through the fourth sub-channel 234, and a gas may pass through the fifth sub-channel 235. The gas in the fifth sub-channel 235 may enter the fourth sub-channel 234 via the through hole in the spacer, so that the gas may be in contact with the first fluid channel 220A, thereby cooling the fluid to be cooled in the first fluid channel 220A and the fluid to be cooled in the first fluid channel 220B by using the gas.

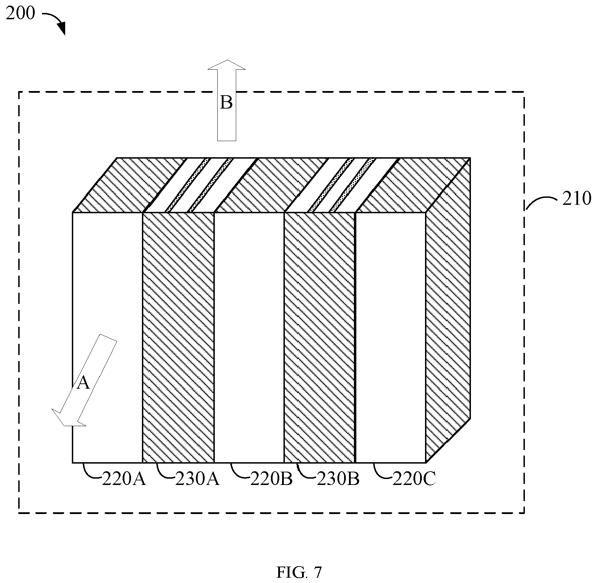

FIG. 7 schematically shows a schematic diagram of a direction of a channel according to an embodiment of the present disclosure.

As shown in FIG. 7, the cooling apparatus 200 according to the embodiment of the present disclosure includes: a main body 210, a plurality of first fluid channels, at least one second fluid channel, and a spacer.

The plurality of first fluid channels include, for example, a first fluid channel 220A, a first fluid channel 220B, and a first fluid channel 220C. The at least one second fluid channel includes, for example, a second fluid channel 230A and a second fluid channel 230B.

In an example, each first fluid channel includes a first inlet and a first outlet, and a direction from the first inlet to the first outlet is a first direction. Taking the first fluid channel 220A as an example, the first direction is direction A.

In an example, each second fluid channel includes a second inlet and a second outlet, and a direction from the second inlet to the second outlet is a second direction. Taking the second fluid channel 230A as an example, the second direction is direction B.

The second direction is different from the first direction. For example, the first direction is a horizontal direction, and a second direction is a vertical direction.

In an example, for a sub-channel used for a liquid to pass through in the second fluid channel 230A, a second inlet of the sub-channel is located, for example, in an upper part, and a second outlet of the sub-channel is located, for example, in an lower part, so that when the liquid passes through the sub-channel, the liquid may flow from up to down under gravity.

In an example, for a sub-channel used for a gas to pass through in the second fluid channel 230A, a second inlet of the sub-channel is located, for example, in an lower part, and a second outlet of the sub-channel is located, for example, in an upper part, so that when the gas passes through the sub-channel, the fluid may flow from bottom to up. There may be a more fully contact between the gas flowing bottom-to-up and the liquid, thereby improving a heat exchange effect between the gas and the liquid.

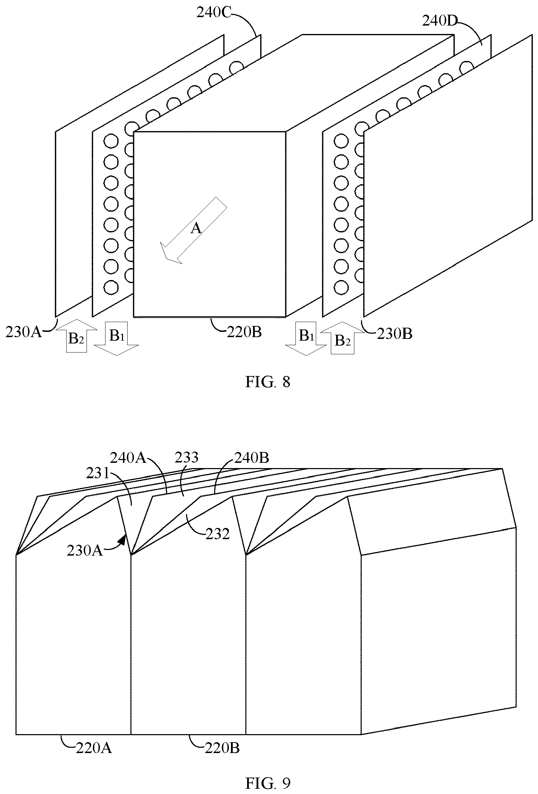

FIG. 8 schematically shows a schematic diagram of a distribution of a spacer according to an embodiment of the present disclosure.

As shown in FIG. 8, the embodiment of the present disclosure provides a first fluid channel 220B, a second fluid channel 230A, and a second fluid channel 230B.

A spacer 240C is used, for example, to divide the second fluid channel 230A into a plurality of sub-channels, and a spacer 240D is used, for example, to divide the second fluid channel 230B into a plurality of sub-channels.

A flow direction of the fluid to be cooled in the first fluid channel 220B is, for example, direction A. For a sub-channel used for a liquid to pass through, a flow direction of the liquid in the sub-channel is, for example, direction B₁. For a sub-channel used for a gas to pass through, a flow direction of the gas in the sub-channel is, for example, direction B₂.

FIG. 9 schematically shows a schematic diagram of a cooling apparatus according to an embodiment of the present disclosure.

As shown in FIG.9, the cooling apparatus according to the embodiment of the present disclosure includes, for example, a main body, a plurality of first fluid channels, at least one second fluid channel, and a plurality of spacers.

In an example, the first fluid channel and the second fluid channel may be provided in various shapes. Taking the plurality of first fluid channels including a first fluid channel 220A and a first fluid channel 220B, and the at least one second fluid channel including, for example, the second fluid channel 230A as an example, for description.

A spacer 240A and a spacer 240B divide the second fluid channel 230A into three sub-channels. The three sub-channels include, for example, a first sub-channel 231, a second sub-channel 232 and a third sub-channel 233.

The first sub-channel 231 and the second sub-channel 232 may be used, for example, for liquids to pass through. Since the cooling effect of the liquid is relative good, the first sub-channel 231 and the second sub-channel 232 adjoining the first fluid channels are provided for the flow of the liquids, so that the liquids may be used to cool the fluids to be cooled in the first fluid channels, thereby improving the cooling efficiency and the cooling effect.

The third sub-channel 233 may be used, for example, for a gas to pass through. The gas may be used to cool the liquid in the first sub-channel 231 and the liquid in the second sub-channel 232. The first sub-channel 231 and the third sub-channel 233 are separated by a spacer 240A provided with a through hole, and the second sub-channel 232 and the third sub-channel 233 are separated by a spacer 240B provided with a through hole. Therefore, the gas may contact the liquids via the through hole for heat exchange, which may improve the cooling effect of the liquids, and further improving the cooling effect of the liquids on the fluids to be cooled.

The present disclosure provides a cooling method implemented by the cooling apparatus 200 according to above-mentioned embodiments of the present disclosure. In the method, a gas is introduced into the third sub-channel 233, and no liquid or gas is introduced into the first sub-channel 231 and the second sub-channel 232.

The present disclosure provides a cooling method implemented by the cooling apparatus 200 according to above-mentioned embodiments of the present disclosure. In the method, a gas is introduced into the third sub-channel 233 and liquids are introduced into the first sub-channel 231 and the second sub-channel 232.

The above-mentioned embodiments do not limit the protection scope of the present disclosure. Those skilled in the art should understand that, various modifications, combinations, sub-combinations and substitutions may be made according to design requirements and other factors. Any modifications, equivalent substitutions and improvements made within the scope and the principle of the present disclosure should all fall within the protection scope of the present disclosure.

## Claims

1. A cooling apparatus (200), comprising:
a main body (210);
a plurality of first fluid channels (220A, 220B, 220C) provided in the main body (210);
at least one second fluid channel (230A, 230B) provided in the main body (210), each second fluid channel of the at least one second fluid channel (230A, 230B) being provided between two adjacent first fluid channels of the plurality of first fluid channels (220A, 220B, 220C), and adjoining the two adjacent first fluid channels; and
a spacer (240A, 240B, 240C) provided in each second fluid channel, the spacer (240A, 240B, 240C) being configured to divide each second fluid channel into a plurality of sub-channels (231, 232, 233, 234, 235).

2. The cooling apparatus (200) according to claim 1, wherein the spacer (240A, 240B, 240C) comprises a through hole (241), and any two adjacent sub-channels of the plurality of sub-channels (231, 232, 233, 234, 235) are configured to communicate with each other through the through hole (241).

3. The cooling apparatus (200) according to claim 1, wherein two spacers are provided in each second fluid channel, and configured to divide the second fluid channel into three sub-channels.

4. The cooling apparatus (200) according to claim 3, wherein the three sub-channels comprise:
a first sub-channel (231), wherein the first sub-channel (231) adjoins one first fluid channel of the two adjacent first fluid channels;
a second sub-channel (232), wherein the second sub-channel (232) adjoins the other one of the two adjacent first fluid channels; and
a third sub-channel (233) provided between the first sub-channel (231) and the second sub-channel (232).

5. The cooling apparatus (200) according to claim 4, wherein any one or more of the first sub-channel (231) and the second sub-channel (232) comprises a curved structure.

6. The cooling apparatus (200) according to claim 1, wherein one spacer is provided in each second fluid channel, and configured to divide the second fluid channel (230A, 230B) into two sub-channels.

7. The cooling apparatus (200) according to claim 6, wherein any one of the two sub-channels comprises a curved structure.

8. The cooling apparatus (200) according to claim 1, wherein each first fluid channel comprises a first inlet and a first outlet, and a direction from the first inlet to the first outlet is a first direction (A).

9. The cooling apparatus (200) according to claim 8, wherein each second fluid channel comprises a second inlet and a second outlet, a direction from the second inlet to the second outlet is a second direction (B), and the first direction (A) is different from the second direction (B).

10. The cooling apparatus (200) according to claim 9, wherein the first direction (A) comprises a horizontal direction, and the second direction (B) comprises a vertical direction.

11. The cooling apparatus (200) according to any one of claims 1 to 10, wherein the spacer (240A, 240B, 240C) comprises a mesh screening.

12. A cooling method implemented by a cooling apparatus (200), wherein the cooling apparatus comprises:
a main body (210);
a plurality of first fluid channels (220A, 220B, 220C) provided in the main body (210);
at least one second fluid channel (230A, 230B) provided in the main body (210), each second fluid channel of the at least one second fluid channel (230A, 230B) being provided between two adjacent first fluid channels of the plurality of first fluid channels (220A, 220B, 220C), and adjoining the two adjacent first fluid channels; and
a spacer (240A, 240B, 240C) provided in each second fluid channel, the spacer (240A, 240B, 240C) being configured to divide each second fluid channel into a plurality of sub-channels (231, 232, 233, 234, 235);
the method comprises:
introducing a fluid into at least one of the plurality of sub-channels (231, 232, 233, 234, 235).

13. The method according to claim 12, wherein two spacers are provided in each second fluid channel, and configured to divide the second fluid channel into three sub-channels;
wherein the three sub-channels comprise:
a first sub-channel (231), wherein the first sub-channel (231) adjoins one first fluid channel of the two adjacent first fluid channels;
a second sub-channel (232), wherein the second sub-channel (232) adjoins the other one of the two adjacent first fluid channels; and
a third sub-channel (233) provided between the first sub-channel (231) and the second sub-channel (232).

14. The method according to claim 13, wherein the fluid comprises a gas, and the introducing a fluid into at least one of the plurality of sub-channels (231, 232, 233, 234, 235) comprises:
introducing the gas into the third sub-channel (233).

15. The method according to claim 14, wherein the fluid further comprises a liquid, and the introducing a fluid into at least one of the plurality of sub-channels (231, 232, 233, 234, 235) further comprises:
introducing liquids into the first sub-channel (231) and the second sub-channel (232).
